# FASCICULE DE BREVET EUROPEEN

(11) **EP 0 990 917 B1**
(45) Date de publication et mention de la délivrance du brevet: **14.01.2004**
(21) Numéro de dépôt: 99402357.0
(22) Date de dépôt: 28.09.1999
(51) Int. Cl.: G01R 31/28, G09G 3/28

(54) **Procédé de test de la connexion des sorties d'au moins un circuit de puissance pour écran à plasma et circuit de puissance pour sa mise en oeuvre.**
Verfahren zum Testen der Verbindung der Ausgangsleiter mindestens einer Leistungsschaltung einer Plasmaanzeige und Leistungsschaltung dafür
Test method of the output connection of at least one power circuit for plasma display and power circuit for its implementation

(30) Priorité: 28.09.1998 FR 9812101
(43) Date de publication de la demande: 05.04.2000
(73) Titulaire: STMicroelectronics S.A., 92120 Montrouge (FR)
(72) Inventeur: Lardeau, Céline, 75116 Paris (FR); Troussel, Gilles, 75116 Paris (FR); Benoit, Eric, 75116 Paris (FR)
(74) Mandataire: Ballot, Paul

(56) Documents cités:
- EP-A- 0 680 067
- US-A- 5 428 300

## Description

La présente invention se rapporte à un procédé de test de la connexion des sorties d'au moins un circuit de puissance pour la commande d'un écran à plasma, ainsi qu'à un circuit de puissance spécialement conçus pour sa mise en oeuvre.

L'invention s'applique dans le domaine de la fabrication et du test des panneaux incorporant un écran à plasma (Plasma Display Panel, en anglais).

Un tel écran à plasma est dit matriciel car il est formé de cellules disposées en matrice de lignes et de colonnes. Une cellule comprend une cavité remplie d'un gaz rare, deux électrodes de commande et un dépôt de phosphore rouge, vert ou bleu. Pour provoquer l'éclairement d'une cellule donnée sur l'écran, on applique une haute tension entre les électrodes de commande de cette cellule. Cette haute tension déclenche une ionisation du gaz dans la cavité qui s'accompagne d'une émission de rayons ultraviolets. L'excitation par ces rayons du phosphore déposé crée, sur l'écran, un point lumineux respectivement rouge, vert ou bleu.

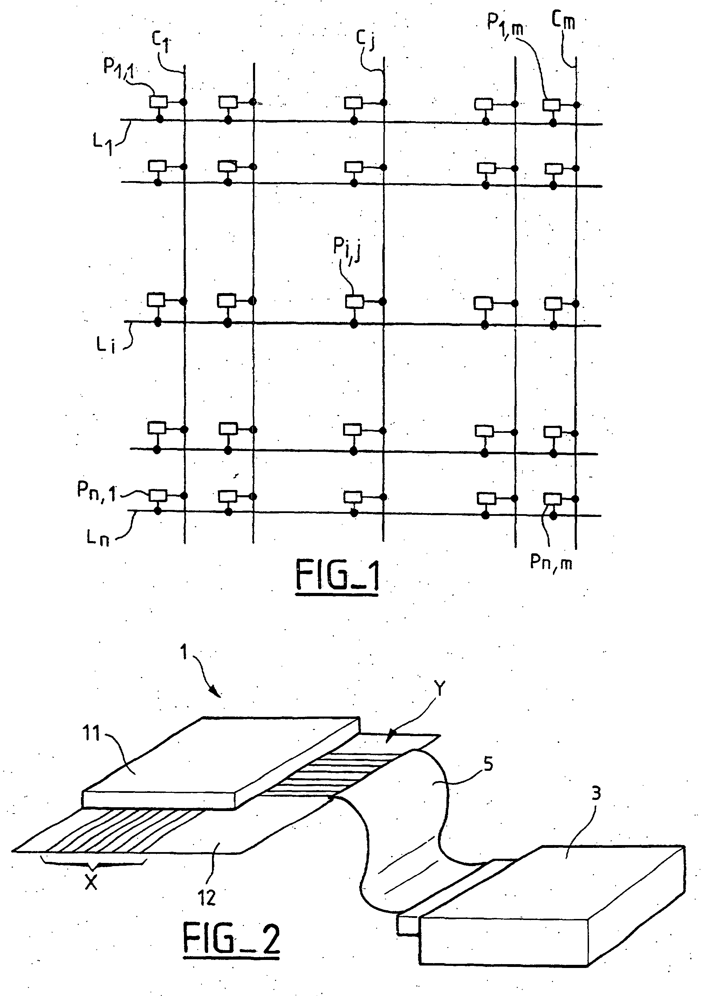

Ainsi qu'on peut le voir représenté à la figure 1, chaque cellule est connectée à l'intersection d'une ligne et d'une colonne. Plus exactement, chaque cellule Pij est connectée par une première électrode de commande à une ligne conductrice Li commune à toutes les cellules d'une même ligne d'indice i, où i est un entier compris entre 1 et n, et par une seconde électrode de commande à une ligne conductrice Cj, commune à toutes les cellules d'une même colonne d'indice j, où j est un entier compris entre 1 et m. Chacune de ces lignes conductrices est reliée vers l'extérieur par l'intermédiaire, respectivement, d'une électrode de ligne ou d'une électrode de colonne. Pour donner un ordre de grandeur, un écran de 50 pouces (50") au format 16/9 comprend environ n = 1000 électrodes de ligne et m = 3000 électrodes de colonne. On parle aussi parfois, respectivement, d'électrodes horizontales ou verticales.

Des circuits de puissance (Drivers, en anglais) délivrent des signaux de commande haute tension pour commander l'éclairement ou le non éclairement des cellules de l'écran. Un tel signal de commande présente, à l'état logique bas, un potentiel nul ou négatif dit potentiel de masse, et, à l'état logique haut, un potentiel (ou une tension référencée par rapport à la masse) de l'ordre de 100 à 150 volts. Les états logiques de tels signaux appliqués sur les électrodes de ligne et de colonne de l'écran déterminent les cellules qui sont commandées pour être éclairées et celles qui sont commandées pour être éteintes. Ces circuits de puissance reçoivent en entrée des signaux de commande basse tension. Un tel signal présente, à l'état logique bas, un potentiel nul, et, à l'état logique haut, un potentiel (ou une tension référencée par rapport à la masse) de 5 volts.

Vis-à-vis des sorties des circuits de puissance, les électrodes du panneau à plasma sont assimilables :
- lors d'une séquence d'adressage (c'est-à-dire lors des changements d'état des signaux de commande haute tension), à un condensateur qui doit être chargé ou déchargé ;
- lors d'une séquence d'entretien (pour assurer l'éclairement ou le non éclairement de la cellule), à un générateur de courant qui doit être fourni ou absorbé par le circuit de puissance.

Les sorties des circuits de puissance sont donc conçues pour fournir ou absorber un courant de l'ordre de plusieurs dizaines de milliampères.

Dans la pratique, l'adressage des lignes est réalisé séquentiellement, c'est à dire ligné après ligne. A cet effet, les électrodes de ligne sont sélectionnées l'une après l'autre par l'application de signaux haute tension appropriés. Des signaux de commande également haute tension sont alors appliqués simultanément sur les électrodes de colonne par les sorties de circuits de puissance. Les différences de potentiel ainsi générées entre les électrodes de commande des cellules déterminent leur état éclairé ou non. L'effet mémoire lié à la nature du gaz contenu dans la cavité de la cellule permet un tel adressage séquentiel des lignes de l'écran

A la figure 2, on a représenté un écran à plasma 1 ainsi que le boîtier 3 d'un module de puissance. Ce boîtier contient , un (ou plusieurs) circuit(s) imprimé(s) sur lequel (lesquels) sont montés les circuits de puissance, en générai sous forme de circuits intégrés. Un circuit intégré contient par exemple jusqu'à 96 étages de sortie de puissance. Les sorties du circuit de puissance sont les sorties de ces étages de puissance. Elles peuvent donc adresser 96 électrodes de l'écran. Dit autrement, la sortie de chaque étage de sortie de puissance du module pilote une électrode de colonne de l'écran. A cet effet, les 96 sorties des circuits intégrés sont reliées à des électrodes de colonnes par des moyens de liaison adaptés, généralement par l'intermédiaire de pistes conductrices gravées sur le circuit imprimé.

L'écran à plasma 1 comprend une plaque de verre 11 montée sur un substrat 12. La face inférieure de la plaque 11 porte les luminophores (non représentés). Les électrodes de lignes désignées globalement par la référence X, et les électrodes de colonnes désignées globalement par la référence Y, dépassent de la plaque de verre 11 sur le substrat 1 2. Des couches de matériaux diélectriques non représentées assurent l'isolation électrique entre les différents éléments ci-dessus. Le pas entre les électrodes est très faible et peut atteindre 100 µm (micromètres).

Le module de puissance comprend le boîtier 3, un connecteur d'entrée des signaux de commande basse tension (non représenté) ainsi que les moyens de liaison précités. Ces moyens comprennent un câble 5, plat et souple, comportant un ensemble de pistes conductrices parallèles, isolées les unes des autres et ayant un pas égal au pas des électrodes de colonne, à savoir 100 µm. Le câble plat 5 est plus généralement un circuit imprimé flexible sur lequel les pistes sont gravées (on parle parfois d'une nappe de pistes conductrices). Il est collé ou pressé sur le bord du substrat 12, au-dessus des électrodes de colonnes Y.

L'assemblage des pistes du câble plat 5 et des électrodes de colonne Y est très critique. En effet, après cet assemblage, les défauts généralement constatés sont de deux types :
- un mauvais contact entre une piste du câble plat. et au moins une électrode de colonne, de sorte que les cellules de la colonne correspondante ne sont pas commandées ;
- un mauvais alignement entre les pistes du câble plat et les électrodes de colonne, de sorte qu'une piste provoque un court-circuit entre deux électrodes de colonne adjacentes.

D'après les fabricants, la proportion de défauts provenant d'électrodes de colonne non connectées, dites électrodes en circuit ouvert, est de 70 %, contre 30 % de défauts provenant d'un court-circuit entre deux électrodes de colonne.

Or, !a seule possibilité de test de l'assemblage des moyens de liaison actuellement mise en oeuvre consiste à mettre le panneau sous tension et à commander l'affichage d'une image prédéterminée. On vérifie ainsi que l'image réellement affichée correspond à celle attendue. Une électrode de ligne ou de colonne non connectée se traduit alors sur l'écran par une ligne, respectivement horizontale ou verticale, qui reste noire.

Cette technique est fiable mais elle ne peut être mise en oeuvre qu'après l'assemblage complet du panneau. Notamment, tous les circuits électroniques du panneau doivent être assemblés, y compris ceux, non représentés à la figure 2, destinés à la génération des signaux de commande basse tension et aux alimentations de puissance. Ceci signifie que, en cas de défaut d'alignement des moyens de liaison entre le module de puissance et l'écran, il peut être nécessaire de démonter tout le panneau pour réviser cet assemblage.

US 5 428 300 A divulgue une méthode de test d'écrans LCD-TFT, l'écran étant formé de cellules capacitives disposées en matrices de lignes et de colonnes et comprenant les étapes consistant à charger une cellule capacitive puis à la décharger et à en déduire la présence de défauts de connections entre la cellule TFT et sa ligne de commande ou de donnée et à répéter ces étapes pour chaque cellule.

L'objet de la présente invention est de pallier aux inconvénients de l'état de technique.

A cet effet, l'invention propose un procédé de test de la connexion des sorties d'au moins un circuit de puissance pour la commande d'un écran à plasma qui est formé de cellules disposées en matrice de lignes et colonnes, les sorties étant reliées à des électrodes capacitivés de ligne ou de colonne auxquelles sont reliées une première électrode des cellules d'une même ligne ou, respectivement, d'une même colonne, qui comporte les étapes suivantes:
a) commutation à l'état haut d'une sortie du circuit de puissance pendant une durée déterminée ;
b) commutation à l'état bas de cette sortie ;
c) mesure du temps de décharge de la sortie par un courant de décharge constant ;
d) en fonction du temps mesuré, détection de présence ou d'absence de charge capacitive connectée à cette sortie ;
e) répétition des étapes a) à d) pour chaque sortie du circuit de puissance.

Ainsi, lorsqu'une électrode est connectée à la sortie considérée du circuit de puissance, le temps de décharge aura une première durée. Lorsque, au contraire, la sortie est en circuit ouvert du fait d'une mauvaise connexion avec l'électrode correspondante, le temps de décharge aura une seconde durée, plus courte que la première. On notera que, dans le second cas, il existe malgré tout une décharge de la sortie du fait notamment de !a capacité parasite de la borne du circuit de puissance et de la capacité parasite due aux pistes conductrices voisines du câble plat qui sont normalement reliées à d'autres électrodes. La seconde durée n'est donc pas nulle.

L'étape d) du procédé consiste à distinguer les deux cas ci-dessus en fonction du temps de décharge mesuré. A cet effet, différentes méthodes seront proposées ci-dessous.

De préférence, à l'étape a), les autres sorties du circuit de puissance sont maintenues à l'état bas. De cette manière, la charge capacitive de la sortie testée est maximale. On peut l'estimer à 50 pF, soit dix fois plus que la charge capacitive parasite d'une sortie en circuit ouvert. De cette manière, la distinction entre les durées de décharge dans l'un ou l'autre cas ci-dessus est plus facile. En effet, l'écart entre les durées mesurées est d'autant plus important que l'écart entre les valeurs des charges capacitives est élevé.

Les durées de décharge sont, dans chaque cas, d'autant plus longues que le courant de décharge est faible. Or, il est d'autant plus facile de distinguer un écart entre deux durées que ces durées sont élevées. C'est pourquoi, de préférence, on prévoit des moyens pour faire en sorte que le courant de décharge soit de faible valeur. Par cette expression, on entend un courant de l'ordre de la centaine de microampères. On montrera qu'on obtient alors des durées de l'ordre de quelques dizaines de microsecondes, que l'on peut aisément distinguer à l'aide de moyens connus.

Un circuit de puissance spécialement conçu pour la mise en oeuvre de ces procédés est également proposé dans la revendication 11.

D'autres caractéristiques et avantages de l'invention apparaîtront encore à la lecture de la description qui va suivre. Celle-ci est purement illustrative et doit être lue en regard des dessins annexés sur lesquels on a représenté :
- à la figure 1, déjà analysée : une matrice de cellules d'un écran à plasma ;
- à la figure 2, également déjà analysée : un écran à plasma relié à un module de puissance ;
- à la figure 3, le schéma d'un étage de sortie de puissance d'un circuit de puissance selon l'invention ;
- à la figure 4, le schéma simplifié d'un circuit de puissance selon l'invention ;
- aux figures 5a à 5g : des chronogrammes de signaux délivrés ou reçus par le circuit de puissance en cas de bonne connexion de la sortie testée ;
- aux figures 6a à 6g, des chronogrammes de signaux délivrés ou reçus par le circuit de puissance en cas de non-connexion de la sortie testée.

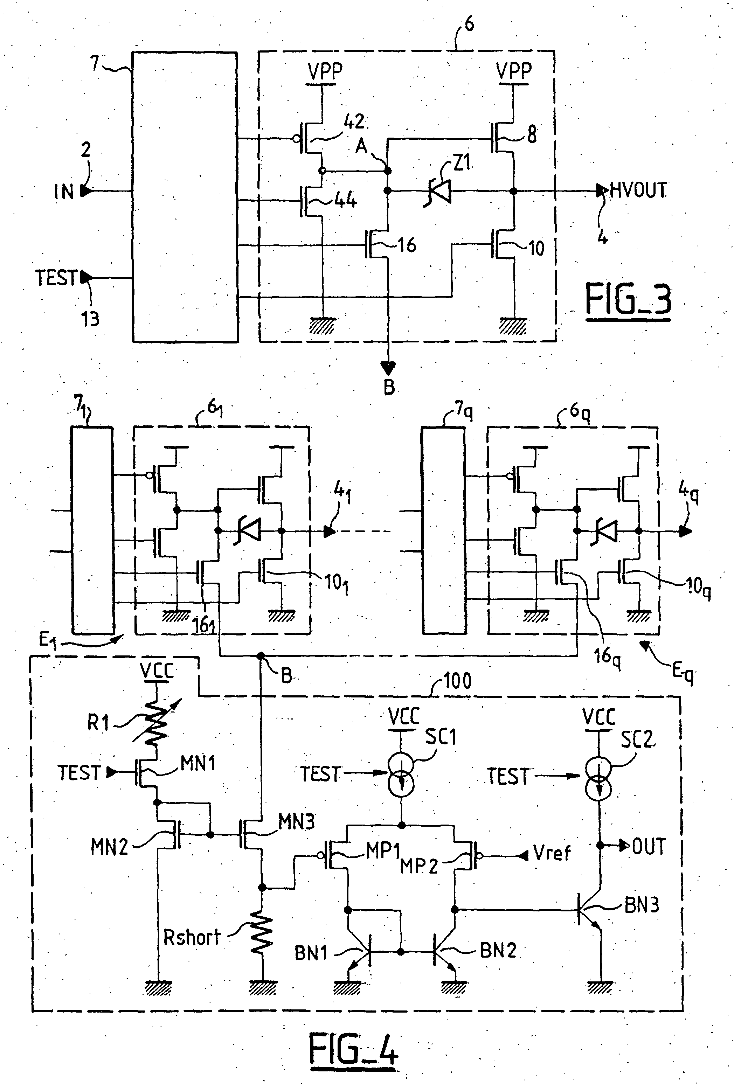

A la figure 3, on a représenté le schéma d'un étage de sortie de puissance d'un circuit de puissance selon l'invention. Un circuit de puissance comporte q sorties (classiquement q vaut 64 ou 96). Il se présente sous forme de circuit intégré. li comporte q étages de sortie de puissance dont les sorties sont les sorties du circuit.

Un étage de sortie de puissance comporte :
- une première entrée 2 pour recevoir un signal de commande IN, qui est un signal logique basse tension ;
- une seconde entrée 13 pour recevoir un signal TEST, qui est un signal logique basse tension qui passe à l'état haut en mode test ;
- une sortie 4 pour délivrer un signal de commande HVOUT, qui est un signal haute tension ;
- un noeud de sortie de test B ;
- un circuit de sortie 6 comprenant un transistor de charge 8 et un transistor de décharge 10 sur lesquels on reviendra ci-dessous,
- des moyens de commande 7 pour générer des signaux pour la commande des transistors 8 et 10 en fonction du signal de commande basse tension IN.

La sortie 4 d'un étage de sortie de puissance tel que celui représenté à la figure 3 est destinée à être reliée à une électrode de colonne de l'écran à plasma, afin que le -signal HVOUT commande l'éclairement ou le non éclairement d'une cellule. Comme on l'a vu, une cellule peut être considérée, du point de vue statique entre ses deux électrodes de commande, comme une capacité équivalente relativement levée, de l'ordre de la dizaine de picofarads (pF). Cette capacité doit être chargée pour éclairer la cellule, et elle doit être déchargée pour l'éteindre.

Compte tenu du potentiel élevé à atteindre pour commander l'éclairement de la cellule et de l'importance de la charge capacitive, le circuit de puissance doit fournir un courant de charge et absorber un courant de décharge relativement élevés, pouvant atteindre plusieurs dizaines de milliampères.

C'est la fonction du circuit de sortie 6 que de fournir et d'absorber de tels courants. A cet effet, le transistor de charge 8 et le transistor de décharge 10 sont des transistors MOS de puissance, en l'occurrence de type N. Plus particulièrement, il s'agit de transistors de type VDMOS qui peuvent supporter de fortes différences de potentiel source-drain et fournir ou absorber des courants importants.

Le drain du transistor de charge 8 est relié à une borne d'alimentation délivrant la haute tension d'alimentation VPP, de l'ordre de la centaine de volts. Sa source est connectée à la sortie 4. De plus, le drain du transistor de décharge 10 est connecté à la sortie 4, et sa source est connectée à la masse GND. La grille de commande du transistor 10 reçoit un signal de commande délivré par les moyens 7.

Dans l'exemple représenté à la figure 3, le transistor 8 fonctionne en transistor MOS de type P composite grâce à l'action d'autres éléments. Le circuit de sortie comporte en effet un transistor MOS de type P référencé 42 dont la source est reliée à une borne d'alimentation délivrant une haute tension d'alimentation VPP, et dont le drain est relié à un noeud A. Il comporte également un transistor MOS de type N référencé 44, dont le drain est relié au noeud A et dont la source est reliée à la masse GND. La grille de commande du transistor de charge 8 est aussi reliée au noeud A. Les grilles de commande des transistors 42 et 44 reçoivent des signaux de commande délivrés par les moyens 7. Ces transistors ont pour fonction de commander indirectement l'état conducteur ou bloqué du transistor 8. Une diode Zaner Z1 est reliée par son anode à la source du transistor 8 et par sa cathode au noeud A. Elle a une fonction de protection de l'oxyde de grille du transistor 8 contre les surtensions. Pour plus d'information sur le fonctionnement de ce transistor MOS de type P composite, on pourra avantageusement se référer à la demande de brevet français FR 2 763 73 du même demandeur.

Comme on l'aura compris, le transistor de charge 8 est rendu conducteur et le transistor de décharge 10 est bloqué pour charger la charge capacitive de manière à commander l'éclairement de la cellule, alors que le transistor de décharge 10 est rendu conducteur et le transistor de charge 8 est bloqué pour décharger la charge capacitive de manière à commander le non-éclairement .de la cellule.

Selon l'invention, le circuit de sortie 6 comporte en outre un transistor MOS de type N, référencé 16, dont le drain est relié au noeud A et la source au noeud de sortie de test B. Il reçoit sur sa grille de commande un signal qui commande sa mise en conduction à certains moments en mode TEST. Dans la suite, ce transistor est dit transistor de décharge en mode TEST. On verra pourquoi par la suite.

Notons que les transistors 8, 42 et 44 peuvent être remplacés par un transistor MOS de type P, tel qu'un transistor de type PMOS sur oxyde épais. Dans ce cas, la diode Z1 est supprimée et le drain du transistor 16 est relié directement à la sortie 4. Ce transistor 8 est alors connecté par sa source à la borne d'alimentation et par son drain à la sortie 4. En outre, il reçoit sur sa grille un signal de commande directement des moyens 7. Néanmoins un tel transistor consomme beaucoup plus de surface de silicium qu'un transistor de type P composite.

Les moyens de commande 7 comprennent en outre des moyens pour empêcher la conduction simultanée des transistors de charge et décharge lors des transitions. On évite ainsi de court-circuiter la source de haute tension VPP et la masse GND. La réalisation des moyens de commande 7 est- à la portée de l'homme du métier. Par conséquent, ces moyens ne seront pas plus détaillés dans la présente description. Le cas échéant, on pourra également se référer à la demande de brevet antérieure citée plus haut.

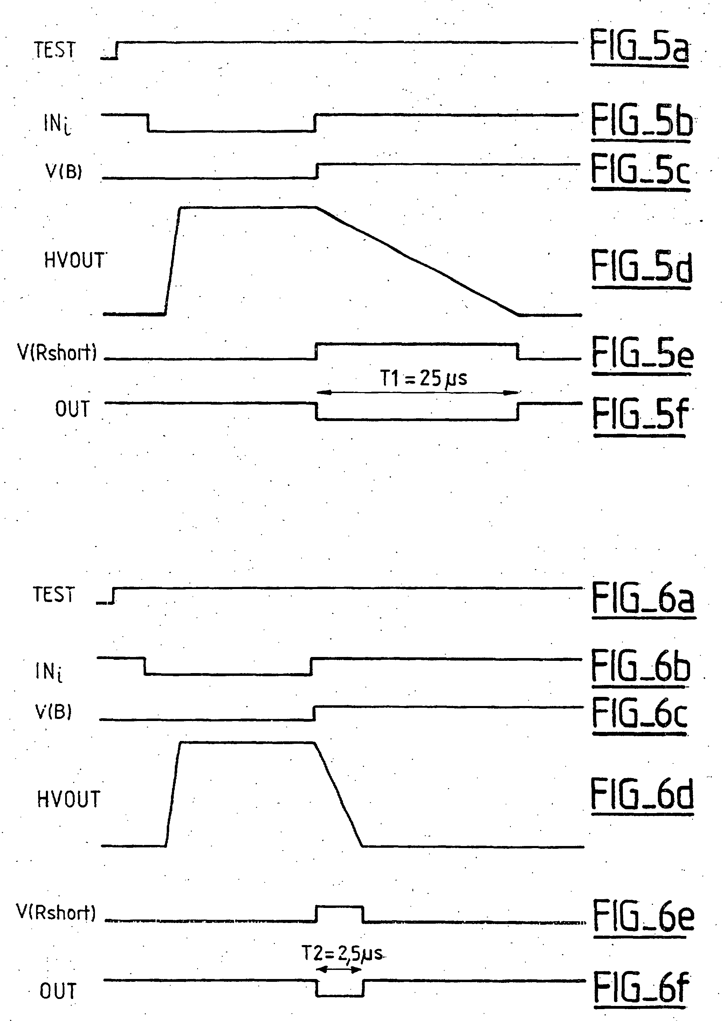

A la figure 4, on a représenté le schéma d'un circuit de puissance selon l'invention. Comme il a été dit plus haut, le circuit de puissance comporte q étages de sortie de puissance tel que celui représenté à la figure 3 Pour simplifier, seul le premier étage E₁ et le dernier étage E_{q} ont été représentés à la figure 4, sur laquelle les mêmes éléments que ceux de la figure 3 portent les mêmes références avec l'indice 1 ou q respectivement.

Les noeuds de sortie de test B des q étages de sortie de puissance sont reliés ensemble. Dit autrement, le noeud B est commun à tous les étages de sortie de puissance du circuit de puissance. Le noeud B est relié à la sortie 4₁, à, 4_{q} de chaque étage par l'intermédiaire de la diode Zéner (Z1 : figure 3) et du transistor de décharge en mode test (16 : figure 3). La diode Zéner de chaque étage a donc une fonction de liaison entre la sortie de l'étage et le noeud de sortie de test B.

Le circuit comporte en outre un étage de test référencé 100. Cet étage comprend une résistance R1 reliée entre une borne d'alimentation recevant une basse tension d'alimentation VCC (qui vaut par exemple 5 volts), et le drain d'un transistor MOS de type N référencé MN1. La source de ce transistor est reliée au drain d'un transistor de type N, référencé MN2, qui est monté en diode. On rappelle que, pour un transistor MOS, un tel montage consiste à relier ensemble le drain et la grille de commande. La source de MN2 est reliée à la masse. La grille de commande de MN1 reçoit le signal TEST. L'étage 100 comprend en outre un transistor MOS de type N, référencé MN3, dont le drain est relié au noeud commun B et dont la source est reliée à la masse à travers une résistance Rshort. La grille de commande de MN3 est reliée à celle de MN2, en sorte que ces deux transistors fonctionnent en miroir de courant.

Les moyens décrits au paragraphe précédent permettent de tirer vers la masse un courant de décharge constant depuis le noeud commun B. Ce courant de décharge circule à travers la résistance Rshort. Il se produit alors une chute de tension à ses bornes. La valeur du courant de décharge est déterminée essentiellement par la valeur de R1 (pour une valeur de VCC fixée). Dans un mode de réalisation, cette valeur peut être ajustée pour tenir compte de la valeur de la charge capacitive reliée aux sorties 4₁, à 4_{q} des étages de sortie de puissance. La valeur du courant de décharge peut ainsi être réglée pour tenir compte des caractéristiques de l'écran à plasma utilisé, ce réglage pouvant être réalisé de manière interne ou externe.

L'étage 100 comprend en outre une paire de transistors MOS de type P, référencés MP1 et MP2 fonctionnant en amplificateur différentiel. A cet effet, les sources de MP1 et MP2 sont reliées ensemble à la borne négative d'une source de courant SC1 dont la borne positive est reliée à une borne recevant la basse tension d'alimentation VCC. Le drain de MP1 est relié au collecteur d'un transistor bipolaire NPN référencé BN1 monté en diode. On rappelle que, pour un transistor bipolaire, un tel montage consiste à relier le collecteur à la base. En outre, le drain de MP2 est relié au collecteur d'un autre transistor bipolaire NPN, référencé BN2. Les émetteurs de BN1 et de BN2 sont reliés à la masse. Leurs bases sont reliées ensemble, en sorte qu'ils fonctionnent en miroir de courant. Le courant est donc le même dans chaque branche de l'amplificateur différentiel. La grille de MP1 est reliée à la source de MN3 pour recevoir la tension aux bornes de Rshort. On note V(Rshort) cette tension. La grille de MP2 reçoit une tension de référence Vref. La tension sur le collecteur de BN2 est donc proportionnelle à la différence entre V(Rshort) et Vref.

Le collecteur de BN2 constitue la sortie de l'amplificateur différentiel. Il est relié à la base d'un transistor bipolaire NPN, référencé BN3. Le collecteur de BN3 est relié à la borne négative d'une source de tension SC2 dont la borne positive est reliée à une borne recevant la basse tension d'alimentation VCC. L'émetteur de BN3 est relié à la masse. Le collecteur de BN3 est la sortie d'un étage de mise en forme constitué par SC2 et BN3. C'est aussi la sortie de l'étage de test 100, qui délivre un signal OUT. Ce signal est un signal logique basse tension. Le transistor BN3 fonctionne en comparateur inverseur.

Le rôle de l'étage de mise en forme est de positionner le signal logique OUT à l'état haut ou à l'état bas en fonction du niveau de la tension à la sortie de l'amplificateur différentiel.

Selon un avantage du mode de réalisation proposé ci-dessus, l'étage de test 100 n'est reproduit qu'une seule fois dans chaque circuit de puissance. Il sert au test des q sorties du circuit successivement.

Le fonctionnement du circuit en mode test est le suivant. La connexion des q sorties du circuit de puissance est testée de manière itérative. Les figures 5a à 5f illustrent le cas d'une sortie testée qui est correctement connectée à une électrode de l'écran. Les figures 6a à 6f illustrent le cas d'une sortie testée qui n'est pas connectée à une électrode de l'écran. Le mode test est activé par le passage à l'état haut du signal TEST (figures 5a et 6a).

Lorsque le signal de TEST est activé, le signal logique qui commande le transistor de décharge 10, garde constamment bloqué ce transistor. La décharge des sorties ne sera commandée que par le transistor 16. Lorsque le mode TEST est désactivé, le transistor 16 est conservé constamment bloqué. La décharge des sorties en fonctionnement normal est réalisée par le transistor de décharge 10.

Les étages de sortie de puissance sont alors commandés de manière que, successivement, chaque sortie soit commutée à l'état haut dans une première étape. La sortie reste dans cet état pendant une durée déterminée correspondant au moins à la durée de la phase d'adressage pendant laquelle l'électrode de l'écran qui est connectée à la sortie testée est chargée (dans le cas bien entendu où cette connexion est correctement réalisée). Cette étape débute lors du passage à l'état bas du signal de commande INᵢ transmis en entrée de l'étage de sortie de puissance Eᵢ correspondant à cette sortie (où i est un indice compris entre 1 et q). Ce changement d'état du signal INᵢ est visible aux figures 5b et 6b. Préférentiellement mais non obligatoirement, les autres sorties du circuit de puissance sont maintenues à l'état bas pendant cette première étape. C'est en effet la configuration qui donne une valeur maximale à la charge capacitive de la sortie testée. En pratique, cette valeur est de l'ordre de 50 pF.

Dans une seconde étape, les étages de sortie de puissance sont commandés de manière, que la sortie commute ensuite à l'état bas. Cette étape débute par le retour à l'état haut du signal INᵢ visible aux figures 5b et 6b. La charge capacitive constituée par l'électrode de l'écran normalement connectée à la sortie testée se décharge alors. On notera que le signal de commande délivré au transistor de décharge 10ᵢ par les moyens de commande 7ᵢ de l'étage Eᵢ est maintenu à l'état bas. A l'inverse, le signal de commande délivré par les moyens 7ᵢ au transistor de décharge en mode test 16ᵢ est à l'état haut. De cette manière, la décharge de la sortie s'effectue non pas à travers le transistor 10ᵢ mais à travers le transistor 16ᵢ. Le courant de décharge circule donc à travers la diode Zéner et le transistor de décharge en mode test de l'étage de sortie de puissance Eᵢ, et à partir du noeud commun B, à travers le transistor MN3 et la résistance Rshort de l'étage de test 100. Ce courant est constant et de valeur fixée par R1, comme on l'a dit plus haut. Aux figures 5c et 6c, on a représenté l'allure de la tension V(B) au noeud commun B. Cette tension est nulle pendant la première étape et est sensiblement égale à la chute de tension aux bornes de Rshort lors de la décharge d'une sortie testée quelconque. On notera en outre que, même si la sortie testée n'est pas connectée à une électrode, il se produit toujours une décharge des capacités parasites liées à la sortie testée. L'ensemble de ces capacités correspond typiquement à une valeur de 5 pF.

De préférence, la valeur de la résistance R1 est telle que le courant de décharge est de faible valeur, de l'ordre de la centaine de microampères. Ainsi, la durée de la décharge de la sortie est d'autant plus longue.

Dans une troisième étape qui débute simultanément avec la deuxième étape ci-dessus, le temps de décharge de la sortie est mesuré. Ceci est réalisé de la manière suivante. D'une part le courant de décharge constant est converti en une tension constante correspondant à la chute de potentiel aux bornes de Rshort. Et d'autre part, l'amplificateur différentiel et l'étage de mise en forme de l'étage 100 produisent une impulsion logique de mesure. Comme on l'aura compris, la longueur de cette impulsion est fonction du temps de décharge.

Dans une dernière étape, la présence ou l'absence de charge capacitive est détectée en fonction du temps mesuré, c'est-à-dire en fait de la longueur de l'impulsion logique de mesure. Cette impulsion est donc traitée selon une méthode appropriée. L'invention propose plusieurs méthodes possibles.

Selon une première méthode, l'impulsion logique de mesure est traitée par des moyens de filtrage temporel. De tels moyens ne transmettent en sortie que des impulsions fournies en entrée qui ont une longueur supérieure à un seuil. Ils comprennent oar exemple une porte logique de type ET dont une entrée reçoit l'impulsion logique de mesure et l'autre entrée reçoit cette impulsion retardée d'une durée correspondant au seuil. Cette méthode est très simple à mettre en oeuvre.

Selon une autre méthode, l'impulsion logique de mesure est comparée avec une impulsion correspondante, dite impulsion de référence, obtenue simultanément pour une autre sortie du circuit de puissance, dite sortie de référence, accompagnée de son circuit de comparaison de type 100.

Dans une première variante, la sortie de référence est en circuit ouvert, c'est-à-dire qu'elle n'est pas connectée à une électrode de l'écran. Il s'agit en quelque sorte d'une sortie surnuméraire, non utilisée pour la commande de l'écran.

La durée de décharge de cette sortie fixe la durée de décharge d'une électrode mal connectée. Toute durée de décharge largement supérieure à cette durée de référence sera considérée comme provenant d'une électrode correctement connectée, à l'erreur près de tenir compte de la capacité parasite liée à la longueur du connecteur flexible.

Dans une seconde variante, la sortie de référence est reliée à une électrode de l'écran. Il peut par exemple s'agir de la première sortie du circuit de puissance.

La méthode selon la première variante est avantageuse car elle élimine les risques d'erreur de détection liés à la dispersion des caractéristiques physiques du circuit de puissance. La méthode selon la seconde variante est encore meilleure dans la mesure où elle élimine les risques d'erreur liés à la dispersion des caractéristiques de l'écran. Dans le second cas, on veillera à ce que les signaux de commande appliqués sur les entrées des étages de sortie de puissance soient tels que la sortie testée et la sortie de référence présentent la même charge capacitive théorique. La charge capacitive d'une sortie dépend d'une part de sa connexion ou non à l'électrode du panneau, et de l'état de tension des deux électrodes "encadrantes". La durée de décharge de l'électrode de référence et de l'électrode testée doivent être égales. Toute différence dénote d'une mauvaise connexion d'une des deux électrodes.

Aux figures 5d à 5f, on a représenté l'allure, respectivement, de la haute tension de commande HVOUT délivrée par la sortie 4ᵢ testée, de la tension V(Rshort) et du signal OUT dans le cas où la sortie testée est correctement connectée à une électrode de l'écran. Aux figures 6d à 6f, on a représenté les mêmes signaux et tension, dans lé cas inverse où la sortie testée est en circuit ouvert.

A la figure 5d, le signal de commande haute tension HVOUT présente, à partir du début de la deuxième et de la troisième étapes, une première pente traduisant une décharge à courant constant de la sortie testée. Cette décharge dure une première durée, qui détermine la longueur de l'impulsion de mesure. Cette longueur T1 de l'impulsion de mesure sur le signal OUT est de l'ordre de 25 µs (avec un courant de décharge de l'ordre de 50 µA, une capacité de charge de l'ordre de 50 pF) et une tension d'alimentation de 25V.

A la figure 6d, le signal de commande haute tension HVOUT présente une seconde pente, comparativement plus raide, qui traduit une décharge à courant constant de la sortie testée qui est plus rapide. Cette décharge dure en effet une seconde durée, plus courte que la première durée ci-dessus. En effet, la longueur T2 de l'impulsion de mesure sur le signal OUT est de l'ordre de 2,5 µs (avec un courant de décharge de l'ordre de 50 µA, une capacité parasite de la sortie de l'ordre de 5 pF) et la même tension d'alimentation de 25V.

On comprend que plus T1 et T2 sont grands, avec le même rapport, et plus il est aisé de les distinguer. D'où l'intérêt de forcer la décharge de la sortie testée par un courant de décharge de faible valeur.

Bien entendu, les étapes ci-dessus sont répétées pour chaque sortie du circuit de puissance.

De plus, on cherchera souvent dans la pratique à tester la connexion des sorties de plusieurs ou de la totalité des circuits de puissance que comporte le module de puissance.

Pour ce faire, l'invention proposé de mettre en oeuvre le procédé de test des sorties d'un circuit de puissance décrit ci-dessus, successivement pour chaque circuit de puissance du module.

En variante, il est aussi possible de mettre en oeuvre ce procédé simultanément pour chaque circuit de puissance du module.

## Revendications

1. Procédé de test de la connexion d'au moins un circuit de puissance pour la commande d'un écran à plasma (1) qui est formé de cellules disposées en matrice de lignes. et colonnes, les sorties du circuit de puissance étant reliées à des électrodes capacitives de ligne ou de colonne auxquelles sont reliées une première électrode des cellules d'une même ligne ou, respectivement, d'une même colonne, le procédé comportant les étapes suivantes :
a) commutation l'état haut d'une sortie (6) du circuit de puissance pendant une durée déterminée ;
b) commutation à l'état bas de cette sortie;
c) mesure du temps de décharge de la sortie par un courant de décharge constant;
d) en fonction du temps mesuré, détection de présence ou d'absence de charge capacitive connectée à cette sortie;
e) répétition des étapes a) à d) pour chaque sortie du circuit de puissance.

2. Procédé selon la revendication 1, **caractérisé en ce que**, à l'étape a), les autres sorties sont maintenues à l'état bas.

3. Procédé selon la revendication 1 ou.selon la revendication 2, **caractérisé en ce que** le courant de décharge est de faible valeur, de l'ordre de la centaine de microampères.

4. Procédé selon l'une des revendications 1 à 3, **caractérisé en ce que**, à l'étape c), le courant de décharge est converti en une tension de manière à produire une impulsion logique de mesure dont la longueur est fonction du temps de décharge.

5. Procédé selon la revendication 4, **caractérisé en ce que** l'étape d) comprend un filtrage- temporel de l'impulsion logique de mesure.

6. Procédé selon la revendication 4, **caractérisé en ce que** l'étape d) comprend une comparaison de l'impulsion logique de mesure avec une impulsion correspondante, dite impulsion de référence, obtenue simultanément pour une autre sortie du circuit de puissance, dite sortie de référence.

7. Procédé selon la revendication 6, **caractérisé en ce que** la sortie de référence est en circuit ouvert.

8. Procédé selon la revendication 6, **caractérisé en ce que** la sortie de référence est reliée à une électrode de l'écran.

9. Procédé de test de la connexion' des sorties de plusieurs circuits de puissance d'un module de puissance, **caractérisé en ce qu'**il consiste à mettre en oeuvre un procédé selon l'une des revendications 1 à 8 successivement pour chaque circuit de puissance du moduie de puissance.

10. Procédé de test de la connexion des sorties de plusieurs circuits de puissance d'un module de puissance, **caractérisé en ce qu'**il consiste à mettre en oeuvre un procédé selon l'une des revendications 1 à 8 simultanément pour chaque circuit de puissance du module de puissance.

11. Circuit de puissance spécialement conçu pour la mise en oeuvre d'un procédé selon l'une des revendications 1 à 8, le circuit de puissance comprenant:
- des étages de sortie de puissance E₁ à E_{q} dont les sorties sont les sorties du circuit de puissance ;
- des moyens pour tirer vers la masse un courant constant de décharge de la sortie 4₁ à 4_{q} de chaque étage de sortie de puissance;
- des moyens pour produire une impulsion logique de mesure dont la durée est fonction du temps de décharge de la sortie testée et qui est destinée à être traitée pour en déduire la présence ou l'absence d'une charge capacitive connectée à la sortie testée.

12. Circuit selon la revendication 11, **caractérisé en ce qu'**il comporte des moyens pour régler le courant de décharge pour tenir compte des caractéristiques de l'écran à plasma utilisé, ce réglage pouvant être réalisé de manière interne ou externe.

## Patentansprüche

1. Verfahren zum Testen der Verbindung mindestens einer Leistungsschaltung zur Steuerung einer Plasmaanzeige (1), die aus Zellen gebildet ist, die in einer Matrix aus Zeilen und Spalten angeordnet sind, wobei die Anschlüsse der Leistungsschaltung mit kapazitiven Elektroden der Zeile oder der Spalte verbunden sind, mit denen eine erste Elektrode aus Zellen einer gleichen Zeile bzw. einer gleichen Spalte verbunden sind, wobei das Verfahren die folgenden Schritte umfasst:
a) Schaltung zum Zustand Hoch eines Anschlusses (6) der Leistungsschaltung während einer vorbestimmten Zeitdauer;
b) Schaltung zum Zustand Tief dieses Anschlusses;
c) Messung der Entladungszeit des Anschlusses durch einen konstanten Entladungsstrom;
d) als Funktion der gemessenen Zeit, Detektion der Gegenwart oder Abwesenheit der kapazitiven Belastung, die mit dem Anschluss verbunden ist;
e) Wiederholung der Schritte a) bis d) für jeden Anschluss der Leistungsschaltung.

2. Verfahren gemäß Anspruch 1, **dadurch gekennzeichnet, dass** die anderen Anschlüsse in Schritt a) im Zustand Tief gehalten werden.

3. Verfahren gemäß Anspruch 1 oder Anspruch 2, **dadurch gekennzeichnet, dass** der Entladungsstrom von geringem Wert ist, in der Ordnung von Hundert Mikroampere.

4. Verfahren gemäß irgendeinem der Ansprüche 1 bis 3, **dadurch gekennzeichnet, dass** der Entladungsstrom in Schritt c) derart in eine Spannung umgewandelt wird, dass ein logischer Messimpuls erzeugt wird, dessen Länge eine Funktion der Entladungszeit ist.

5. Verfahren gemäß Anspruch 4, **dadurch gekennzeichnet, dass** der Schritt d) ein zeitliches Filtern des logischen Messimpulses umfasst.

6. Verfahren gemäß Anspruch 4, **dadurch gekennzeichnet, dass** der Schritt d) einen Vergleich des logischen Messimpulses mit einem entsprechenden Impuls, Referenzimpuls genannt, umfasst, der gleichzeitig für einen anderen Anschluss der Leistungsschaltung, Referenzanschluss genannt, erhalten wird.

7. Verfahren gemäß Anspruch 6, **dadurch gekennzeichnet, dass** der Referenzanschluss in Leerlaufschaltung ist.

8. Verfahren gemäß Anspruch 6, **dadurch gekennzeichnet, dass** der Referenzanschluss mit einer Elektrode der Anzeige verbunden ist.

9. Verfahren zum Testen der Verbindung der Anschlüsse mehrerer Leistungsschaltungen eines Leistungsmoduls, **dadurch gekennzeichnet, dass** es aus Verwenden eines Verfahrens gemäß irgendeinem der Ansprüche 1 bis 8 aufeinanderfolgend für jede Leistungsschaltung des Leistungsmoduls besteht.

10. Verfahren zum Testen der Verbindung der Anschlüsse mehrerer Leistungsschaltungen eines Leistungsmoduls, **dadurch gekennzeichnet, dass** es aus Verwenden eines Verfahrens gemäß irgendeinem der Ansprüche 1 bis 8 gleichzeitig für jede Leistungsschaltung des Leistungsmoduls besteht.

11. Leistungsschaltung, die speziell zur Verwendung eines Verfahrens gemäß irgendeinem der Ansprüche 1 bis 8 entworfen ist, wobei die Leistungsschaltung umfasst:
- Leistungsanschlussstufen E₁ bis E_{q}, deren Anschlüsse die Anschlüsse der Leistungsschaltung sind;
- Mittel zum Ziehen eines konstanten Entladungsstrom von dem Anschluss 4₁ bis 4_{q} jeder Leistungsanschlussstufe auf die Masse;
- Mittel zum Erzeugen eines logischen Messimpulses, dessen Dauer eine Funktion der Entladungszeit des getesteten Anschlusses ist und der bestimmt ist, verarbeitet zu werden, um die Gegenwart oder die Abwesenheit einer kapazitiven Belastung daraus herzuleiten, die mit dem getesteten Anschluss verbunden ist.

12. Schaltung gemäß Anspruch 11, **dadurch gekennzeichnet, dass** sie Mittel zur Einstellung des Entladungsstroms enthält, um die Charakteristiken der verwendeten Plasmaanzeige zu berücksichtigen, wobei diese Einstellung auf eine interne oder externe Weise realisiert sein kann.

## Claims

1. A method of testing the connection of at least one driver for controlling a plasma screen (1) formed by cells disposed as a matrix of lines and columns, the outputs of the driver being connected to capacitative line or column electrodes to which there are connected a first electrode of the cells of the same line or respectively the same column, the method comprising the following steps:
a) switching an output (6) of the driver to the high state for a given duration;
b) switching said output to the low state;
c) measuring the discharge time of the output by a constant discharge current;
d) detecting as a function of the measured time the presence or absence of a capacitative load connected to said output;
e) repetition of steps a) to d) for each driver output.

2. A method according to claim 1, **characterised in that** in step a) the other outputs are held in the low state.

3. A method according to claim 1 or 2, **characterised in that** the discharge current is of a low value, of the order of some hundred microamps.

4. A method according to any one of claims 1 to 3, **characterised in that** in step c) the discharge current is converted to a voltage so as to produce a logic measuring pulse the length of which is a function of the discharge time.

5. A method according to claim 4, **characterised in that** the step d) comprises time filtering of the logic measuring pulse.

6. A method according to claim 4, **characterised in that** the step d) comprises a comparison of the logic measuring pulse with a corresponding pulse, termed the reference pulse, obtained simultaneously for another output of the driver, termed the reference output.

7. A method according to claim 6, **characterised in that** the reference output is in open circuit.

8. A method according to claim 6, **characterised in that** the reference output is connected to an electrode of the screen.

9. A method of testing the connection of the outputs of a plurality of drivers of a power module, **characterised in that** it comprises performing a method according to any one of claims 1 to 8 successively for each driver of the power module.

10. A method of testing the connection of the outputs of a plurality of drivers of a power module, **characterised in that** it comprises performing a method according to any one of claims 1 to 8 simultaneously for each driver of the power module.

11. A driver specially designed for performing a method according to any one of claims 1 to 8, the driver comprising:
- power output stages E₁ to E_{q}, the outputs of which are the driver outputs;
- means for drawing to earth a constant discharge current from the output (4a to 4q) of each power output stage;
- means for producing a logic measuring pulse the duration of which is a function of the discharge time of the tested output and which is intended to be processed to deduce therefrom the presence or absence of a capacitative load connected to the tested output.

12. A circuit according to claim 11, **characterised in that** it comprises means for controlling the discharge current so as to take into account the characteristics of the plasma screen used, such regulation being effected internally or externally.
